# EUROPEAN PATENT APPLICATION

(11) **EP 4 761 549 A1**
(43) Date of publication of application: **17.06.2026**
(21) Application number: 25215527.0
(22) Date of filing: 13.11.2025
(51) Int. Cl.: H10K 59/80, H10K 59/35, H10K 50/852

(54) **ELECTROLUMINESCENT DISPLAY DEVICE**

(30) Priority: 12.12.2024 KR 20240184625
(71) Applicant: LG Display Co., Ltd., Seoul, 07336 (KR)
(72) Inventor: LIM, Kimin, 10845 Paju-si, Gyeonggi-do (KR); KOH, YuRi, 10845 Paju-si, Gyeonggi-do (KR); SHIN, Kilyong, 10845 Paju-si, Gyeonggi-do (KR); HAN, KyuIl, 10845 Paju-si, Gyeonggi-do (KR); KIM, Hyunsuk, 10845 Paju-si, Gyeonggi-do (KR)
(74) Representative: Viering, Jentschura & Partner mbB Patent- und Rechtsanwälte

(57) **Abstract**

An electroluminescent display device can include a substrate (100), a first electrode (400) on the substrate (100), a light emitting unit (500) including a light emitting layer disposed on the first electrode (400), and a second electrode (600) on the light emitting unit (500). A peak wavelength of a photoluminescence (PL) spectrum of the light emitting layer is shorter than a peak wavelength of an out-coupling OC curve of the light emitting unit (500) at a front viewing angle, and is longer than a peak wavelength of the OC curve of the light emitting unit (500) at a 45° side viewing angle.

## Description

### BACKGROUND

### Field of Technology

The present disclosure relates to an electroluminescent display device.

### Discussion of the Related Art

The electroluminescent display device includes a first electrode, a second electrode, and a light emitting layer disposed between the first electrode and the second electrode, and displays an image by emitting the light emitting layer by an electric field between the first electrode and the second electrode.

The electroluminescent display devices are applied to various display devices such as rollable, bendable, and edge bending, and in this case, good image quality is needed not only at a front viewing angle but also at a side viewing angle.

However, in a conventional case, since luminance and color reproducibility are designed to fit the front viewing angle, there is a limitation that the luminance decreases and a desired color cannot be implemented at the side viewing angle.

### SUMMARY OF THE DISCLOSURE

The present disclosure has been made in view of the above problems and it is an aspect of the present disclosure to provide an electroluminescent display device with excellent image quality not only at a front viewing angle but also at a side viewing angle. To this end, the present disclosure provides an electroluminescent display device according to claim 1. Further embodiments are described in the dependent claims.

In accordance with an aspect of the present disclosure, the above and other technical effects can be accomplished by the provision of an electroluminescent display device comprising a substrate, a first electrode on the substrate, a light emitting unit including a light emitting layer disposed on the first electrode, and a second electrode on the light emitting unit, wherein a peak wavelength of a photoluminescence (PL) spectrum of the light emitting layer is shorter than a peak wavelength of an out-coupling (OC) curve of the light emitting unit at a front viewing angle, and is longer than a peak wavelength of the OC curve of the light emitting unit at a 45° side viewing angle.

In addition, in accordance with an aspect of the present disclosure, the above and other technical effects can be accomplished by the provision of an electroluminescent display device comprising a substrate, a first electrode on the substrate, a light emitting unit including a light emitting layer disposed on the first electrode, and a second electrode on the light emitting unit, wherein an overlapping area between a PL spectrum of the light emitting layer and an OC curve of the light emitting unit at one side viewing angle between 0° and 30° is larger than an overlapping area between the PL spectrum of the light emitting layer and the OC curve of the light emitting unit at a front viewing angle.

It is to be understood that both the foregoing general description and the following detailed description are examples and explanatory and are intended to provide further explanation of the inventive concepts as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description explain the principle of the disclosure. In the drawings:
FIG. 1 is a schematic cross-sectional view of an electroluminescent display device according to an embodiment of the present disclosure.
FIG. 2A is a schematic cross-sectional view of a light emitting unit according to an embodiment of the present disclosure.
FIG. 2B is a schematic cross-sectional view of a light emitting unit according to another embodiment of the present disclosure.
FIG. 3 is a graph showing an electroluminescence (EL) spectrum according to an embodiment of the present disclosure.
FIG. 4 is a graph showing a photoluminescence (PL) spectrum according to various embodiments of the present disclosure.
FIG. 5 is a graph showing a color coordinate value and light efficiency of light according to various embodiments of the present disclosure.
FIG. 6A is a graph showing a luminance change according to a viewing angle change of light having a PL spectrum (PL_Ref) according to a comparative example, and FIG. 6B is a table showing a color coordinate (CIEx @0°) at a front viewing angle (0°) and a luminance ratio (Lum@45°) at a side viewing angle (45°) of light having a PL spectrum (PL_Ref) according to the comparative example.
FIG. 7A is a graph showing a luminance change according to a viewing angle change of light having a PL spectrum (PL_Example 1) according to a first embodiment of the present disclosure, and FIG. 7B is a table showing a color coordinate (CIEx @0°) at a front viewing angle (0°) and a luminance ratio (Lum@45°) at a side viewing angle (45°) of light having a PL spectrum (PL_Example 1) according to the first embodiment.
FIG. 8A is a graph showing a luminance change according to a viewing angle change of light having a PL spectrum (PL_Example 2) according to a second embodiment of the present disclosure, and FIG. 8B is a table showing a color coordinate (CIEx @0°) at a front viewing angle (0°) and a luminance ratio (Lum@45°) at a side viewing angle (45°) of light having a PL spectrum (PL_Example 2) according to the second embodiment.
FIG. 9A is a graph showing a luminance change according to a viewing angle change of light having a PL spectrum (PL_Example 3) according to a third embodiment of the present disclosure, and FIG. 9B is a table showing a color coordinate (CIEx @0°) at a front viewing angle (0°) and a luminance ratio (Lum@45°) at a side viewing angle (45°) of light having a PL spectrum (PL_Example 3) according to the third embodiment.
FIG. 10A is a graph showing an out-coupling (OC) curve in a green wavelength band according to various examples at a front viewing angle, and FIG. 10B is a peak wavelength and a FWHM of various OC curve and a color coordinate (CIEx @0°) of emission light in a green wavelength band of FIG. 10A.
FIG. 11A is a graph showing an OC curve in a green wavelength band according to various examples at a side viewing angle (45°), and FIG. 11B is a peak wavelength and a FWHM of various OC curve and a color coordinate (CIEx @45°) of emission light in a green wavelength band of FIG. 11A.
FIG. 12 is a graph showing color coordinate values and luminance rates of emitted light by applying a PL spectrum and various OC curves according to an embodiment of the present disclosure.

Throughout the drawings and the detailed description, unless otherwise described, the same drawing reference numerals should be understood to refer to the same elements, features, and structures. The relative size and depiction of these elements can be exaggerated for clarity, illustration, and convenience.

### DETAILED DESCRIPTION OF THE EMBODIMENTS

Reference will now be made in detail to embodiments of the present disclosure, examples of which can be illustrated in the accompanying drawings. The progression of processing steps and/or operations described is an example; however, the sequence of steps and/or operations is not limited to that set forth herein and can be changed as is known in the art, with the exception of steps and/or operations necessarily occurring in a particular order. Names of the respective elements used in the following explanations can be selected only for convenience of writing the specification and can be thus different from those used in actual products.

Advantages and features of the present disclosure, and implementation methods thereof, will be clarified through the following examples described with reference to the accompanying drawings. The present disclosure may, however, be embodied in different forms and should not be construed as limited to the examples set forth herein. Rather, these examples are provided so that the specification of the present disclosure will be thorough, complete, and fully convey the scope of the present disclosure to those skilled in the art. Further, the scope of the present disclosure is only defined by of the accompanying claims.

The shapes, sizes, dimensions (e.g., length, width, height, thickness, radius, diameter, area, etc.), ratios, angles, number of elements, and the like illustrated in the accompanying drawings for describing the embodiments of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

Like reference numerals refer to like elements throughout the specification. In the following description, when the detailed description of the relevant known function or configuration is determined to unnecessarily obscure an important point of the present disclosure, the detailed description will be omitted. In a case where 'comprise', 'have', and 'include' described in the present disclosure are used, another portion can be added unless 'only' is used. The terms of a singular form can include plural forms unless referred to the contrary.

In interpreting the components, it is interpreted as including an error range even if there is no separate explicit description of an error range.

In describing a position relationship, for example, when the position relationship is described as 'upon', 'above', 'below' and 'next to', one or more portions can be disposed between two other portions unless 'just' or 'direct' is used. The terms, such as "below," "lower," "above," "upper", and the like, can be used herein to describe a relationship between elements as illustrated in the drawings. It will be understood that the terms are spatially relative and based on the orientation depicted in the drawings.

A description of a time relationship can include a case in which the temporal precedence relationship is described as "after", "following", or "before", etc., and is not continuous unless "right away" or "directly", is used.

Although the first, second, and the like are used to describe various components, these components are not limited by these terms. These terms are used only to distinguish one component from another. Therefore, a first component mentioned below can be a second component within a technical idea of a present disclosure.

It will be understood that, although the terms such as "first," "second," "A," "B," "(a)," and "(b)", etc., can be used herein to describe various elements, these elements should not be limited by these terms. These terms are only used to distinguish one element from another. For example, a first element could be termed a second element, and, similarly, a second element could be termed a first element, without departing from the scope of the present disclosure.

If a component is stated to be "connected," "coupled," or "attached" to another component, that component can be connected, coupled, or attached directly to that other component, but it should be understood that other components can be interposed between each component that can be connected, coupled, or attached indirectly, without any specific description.

It should be understood that, if a component or layer is stated to be "in contact" or "overlapping" with another component or layer, the component or layer can be in direct contact or overlapping with another component or layer, but other components can be interposed between the components that can be indirectly in contact or overlapping without explicit description.

To further elaborate, as used herein, the term "connected" is intended to have the broadest possible meaning. Specifically, the phrase "A is connected to B" encompasses both a direct connection-where no intervening components or elements are present-and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The term "coupled" and "in contact" should be interpreted in the same manner.

The term "at least one" should be understood as including any and all combinations of one or more of the associated listed items. For example, the meaning of "at least one of a first element, a second element, or a third element" compasses the combination of all three listed elements, combinations of any two of the three elements, as well as each individual element, i.e., the first element, the second element, or the third element.

Terms such as "first direction", "second direction", "third direction", "X-axis direction", "Y-axis direction", "Z-axis direction," etc. should not be interpreted only as a geometric relationship perpendicular to each other, but can mean that the configuration of the present disclosure has a wider direction within a range in which the configuration of the present disclosure can functionally act. Further, the term "can" fully encompasses all the meanings and coverages of the term "may" and vice versa.

Features of each of the various examples of the present disclosure can be partially or entirely coupled or combined with each other, technically various interworking and driving are possible, and each of the examples can be independently implemented with respect to each other or can be implemented together in a related relationship.

Hereinafter, various embodiments of the present disclosure will be described in detail with reference to the accompanying drawings. All the components of each display device/apparatus according to all embodiments of the present disclosure are operatively coupled and configured.

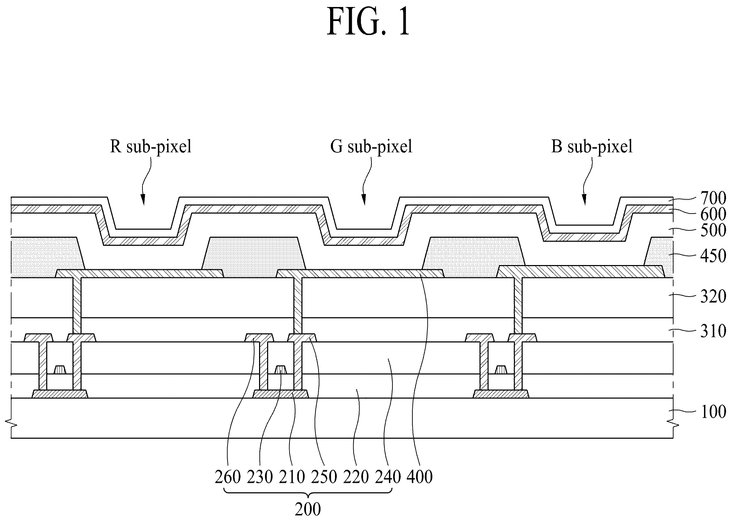

FIG. 1 is a schematic cross-sectional view of an electroluminescent display device according to an embodiment of the present disclosure.

As shown in FIG. 1, the electroluminescent display device according to an embodiment of the present disclosure includes a substrate 100, a circuit element layer 200, a passivation layer 310, a planarization layer 320, a first electrode 400, a bank 450, a light emitting unit 500, a second electrode 600, and a capping layer 700.

The substrate 100 can be made of glass, plastic, or semiconductor material, but is not limited thereto. The electroluminescent display device according to an embodiment of the present disclosure can be made of a top emission type, and accordingly, not only a transparent material but also an opaque material can be used as a material of the first substrate 100.

The circuit element layer 200 is disposed on the substrate 100.

The circuit element layer 200 includes a driving thin film transistor disposed for each of red, green, and blue sub-pixels (R sub-pixels, G sub-pixels, and B sub-pixels).

The driving thin film transistor includes an active layer 210 disposed on the substrate 100, a gate insulating layer 220 disposed on the active layer 210, a gate electrode 230 disposed on the gate insulating layer 220, an interlayer insulating layer 240 disposed on the gate electrode 230, and a source electrode 250 and a drain electrode 260 disposed on the interlayer insulating layer 240.

The source electrode 250 and the drain electrode 260 are connected to one side and the other side of the active layer 210 through holes disposed in the interlayer insulating layer 240 and the gate insulating layer 220.

Although a driving thin film transistor having a top gate structure in which the gate electrode 230 is disposed on the active layer 210 is illustrated in the drawing, the present disclosure can include a driving thin film transistor having a bottom gate structure in which the gate electrode 230 is disposed under the active layer 210. In addition, although the gate insulating layer 220 is disposed on an entire surface of the substrate 100, the gate insulating layer 220 can be patterned in the same manner as the gate electrode 230 under the gate electrode 230. The driving thin film transistor can be changed into various forms known in the art.

In addition, the circuit element layer 200 can further include various signal lines including gate line, data line, power line, and reference line, various thin film transistors including switching thin film transistors and sensing thin film transistors, and capacitors.

The switching thin film transistor is switched according to a gate signal supplied to the gate line to supply a data voltage supplied from the data line to the driving thin film transistor.

The driving thin film transistor is switched according to the data voltage supplied from the switching thin film transistor to generate a data current from a power source supplied from the power line and supply the data current to the first electrode 400.

The sensing thin film transistor can sense a threshold voltage deviation of the driving thin film transistor, which causes image quality deterioration, and supplies a current of the driving thin film transistor to the reference line in response to a sensing control signal supplied from the gate line or a separate sensing line.

The capacitor can maintain the data voltage supplied to the driving thin film transistor for one frame, and be connected to a gate terminal and a source terminal of the driving thin film transistor, respectively.

The passivation layer 310 is disposed on the circuit element layer 200. Specifically, the passivation layer 310 is disposed on the source electrode 250 and the drain electrode 260. The passivation layer 310 can be formed of an inorganic insulating material, but is not limited thereto.

The planarization layer 320 is disposed on the passivation layer 310. The planarization layer 320 can be made of an organic insulating material.

The passivation layer 310 and the planarization layer 320 include a contact hole, and the source electrode 250 can be exposed through the contact hole, and the first electrode 400 can be connected to the source electrode 250 exposed through the contact hole. In some cases, the drain electrode 260 can be exposed through the contact hole disposed in the passivation layer 310 and the planarization layer 320, and the first electrode 400 can be connected to the drain electrode 260 exposed through the contact hole.

The first electrode 400 is disposed in each of sub-pixels (R sub-pixel, G sub-pixel, B sub-pixel) on the planarization layer 320.

The first electrode 400 is connected to the source electrode 250 or the drain electrode 260 through the contact hole disposed in the passivation layer 310 and the planarization layer 320.

The electroluminescent display device according to an embodiment of the present disclosure can be formed by the top emission type, and accordingly, the first electrode 400 can include a reflective electrode.

The bank 450 is disposed on the planarization layer 320, and is disposed at a boundary between sub-pixels (R sub-pixel, G sub-pixel, B sub-pixel).

The bank 450 is disposed on the first electrode 400 to cover an edge of the first electrode 400. A light emitting area can be defined by the bank 450. Specifically, a portion of the first electrode 400 exposed without being covered by the bank 450 can be a light emitting area.

The light emitting unit 500 is disposed in the light emitting area defined by the bank 450. The light emitting unit 500 is disposed on the first electrode 400, particularly, on a portion of the first electrode 400 exposed without being covered by the bank 450. In addition, the light emitting unit 500 can be disposed on an upper surface of the bank 450. For example, the light emitting unit 500 can also be disposed at a boundary between the sub-pixels (R sub-pixels, G sub-pixels, and B sub-pixels).

The second electrode 600 is disposed on the light emitting unit 500.

The second electrode 600 is formed to be continuous without being disconnected in the sub-pixel (R sub-pixel, G sub-pixel, B sub-pixel).

The electroluminescent display device according to an embodiment of the present disclosure can be configured by the top emission type, and thus the second electrode 600 can include a transparent electrode or a translucent electrode.

The capping layer 700 is disposed on the second electrode 600. The capping layer 700 can include an organic insulating material, and can cover particles that can remain on an upper surface of the second electrode 600.

An encapsulation layer can be additionally disposed on the capping layer 700.

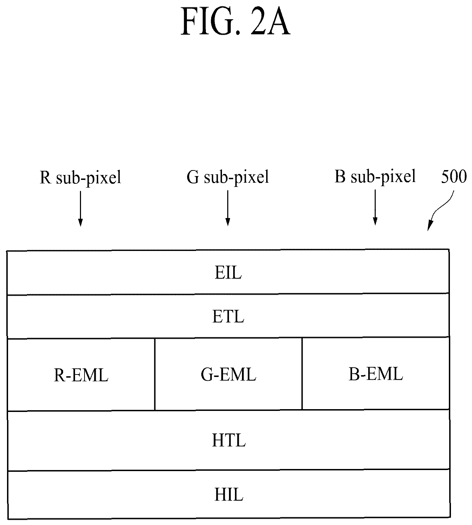

FIG. 2A is a schematic cross-sectional view of a light emitting unit according to an embodiment of the present disclosure.

As can be seen from FIG. 2A, the light emitting unit 500 according to an embodiment of the present disclosure includes a hole injection layer (HIL), a hole transport layer (HTL), a light emitting layer (R-EML, G-EML, B-EML), an electron transport layer (ETL), and an electron injection layer (EIL).

The hole injection layer HIL is disposed on the first electrode 400 and the bank 450 of FIG. 1 described above, and can be formed to be continuous without being disconnected in red, green, and blue sub-pixels (R sub-pixels, G sub-pixels, and B sub-pixels).

In the present disclosure, when a material layer is formed to be continuous without being disconnected in the plurality of sub-pixels, it means that the material layer is continuous in the plurality of sub-pixels and in a boundary area therebetween.

The hole transport layer HTL is disposed on the hole injection layer HIL, and can be formed to be continuous without being disconnected in red, green, and blue sub-pixels (R sub-pixels, G sub-pixels, and B sub-pixels).

The hole transport layer HTL is formed to have different thicknesses and be disconnected in red, green, and blue sub-pixels (R sub-pixel, G sub-pixel, B sub-pixel), thereby obtaining a microcavity effect for each sub-pixel (R sub-pixel, G sub-pixel, B sub-pixel). In this case, considering that red is a longer wavelength than green and green is a longer wavelength than blue, a thickness of the hole transport layer HTL of the red sub-pixel (R sub-pixel) is thicker than a thickness of the hole transport layer HTL of the green sub-pixel (G sub-pixel), and the thickness of the hole transport layer HTL of the green sub-pixel (G sub-pixel) can be thicker than a thickness of the hole transport layer HTL of the blue sub-pixel (B sub-pixel).

In some cases, an additional second hole transport layer for obtaining the microcavity effect can be additionally disposed between hole transport layer HTL that is continuous without being disconnected in the sub-pixels (R sub-pixel, G sub-pixel, B sub-pixel) and the light emitting layer (R-EML, G-EML, and B-EML). In this case, a thickness of the second hole transport layer of the red sub-pixel (R sub-pixel) is thicker than a thickness of the second hole transport layer of the green sub-pixel (G sub-pixel), and the thickness of the second hole transport layer of the green sub-pixel (G sub-pixel) can be thicker than a thickness of the second hole transport layer of the blue sub-pixel (B sub-pixel).

An electron blocking layer EBL can be additionally disposed between the hole transport layer HTL and the light emitting layers (R-EML, G-EML, and B-EML). In order to implement microcavity, when a thickness of the hole transport layer HTL is different for each sub-pixel (R sub-pixel, G-pixel, and B sub-pixel), the electron blocking layer EBL can be disposed at different positions for each sub-pixel (R sub-pixel, G-pixel, and B sub-pixel).

The light emitting layers R-EML, G-EML, and B-EML are disposed on the hole transport layer HTL.

The light emitting layers R-EML, G-EML, and B-EML include a red light emitting layer R-EML disposed in the red sub-pixel (R sub-pixel), a green light emitting layer G-EML disposed in the green sub-pixel (G sub-pixel), and a blue light emitting layer B-EML1 disposed in the blue sub-pixel (B sub-pixel).

At least one of the red light emitting layer R-EML, the green light emitting layer G-EML, and the blue light emitting layer B-EML can be formed of a multi-layered light emitting layer. For example, the red light emitting layer R-EML and the green light emitting layer G-EML can be formed of a single light emitting layer, and the blue light emitting layer B-EML can be formed of a multi-layered light emitting layer.

The red light emitting layer R-EML, the green light emitting layer G-EML, and the blue light emitting layer B-EML may not overlap each other, but are not limited thereto. In addition, the red light emitting layer R-EML, the green light emitting layer G-EML, and the blue light emitting layer B-EML can be formed not to be in contact with each other.

The electron transport layer ETL is disposed on the light emitting layers R-EML, G-EML, and B-EML, and can be formed to be continuous without being disconnected in red, green, and blue sub-pixels (R sub-pixels, G sub-pixels, and B sub-pixels).

A hole blocking layer HBL disposed between the light emitting layers R-EML, G-EML, and B-EML and the electron transport layer ETL can be additionally included.

The electron injection layer EIL is disposed on the electron transport layer ETL, and can be formed to be continuous without being disconnected in red, green, and blue sub-pixels (R sub-pixels, G sub-pixels, and B sub-pixels).

According to an embodiment of the present disclosure, the light emitting layers R-EML, G-EML, and B-EML include the red light emitting layer R-EML, the green light emitting layer G-EML, and the blue light emitting layer B-EML Accordingly, without a separate color filter, red light can be emitted from the red sub-pixel (R sub-pixel), green light can be emitted from the green sub-pixel (G sub-pixel), and blue light can be emitted from the blue sub-pixel (B sub-pixel).

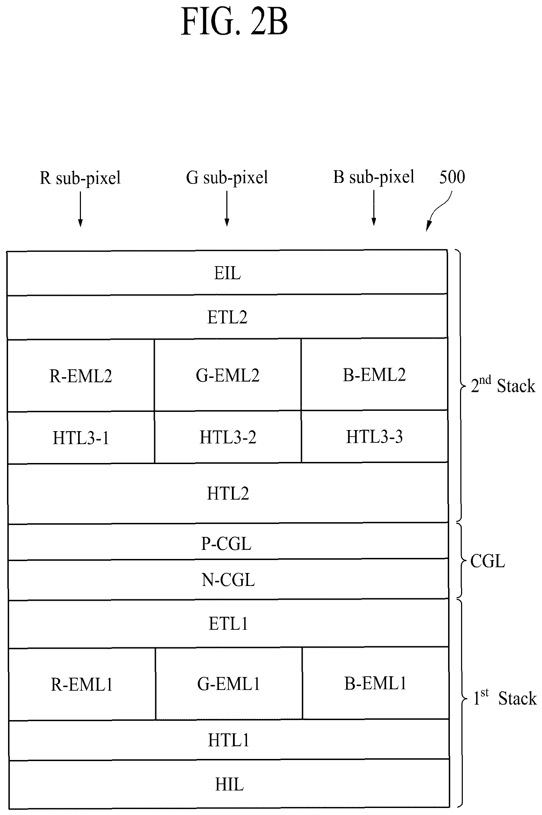

FIG. 2B is a schematic cross-sectional view of a light emitting unit according to another embodiment of the present disclosure.

As shown in FIG. 2B, the light emitting unit 500 according to another embodiment of the present disclosure includes a first stack (1^{st} Stack), a second stack (2^{nd} Stack), and a charge generation layer CGL.

The first stack (1^{st} Stack) includes a hole injection layer HIL, a first hole transport layer HTL1, a first light emitting layer R-EML1, G-EML1, and B-EML1, and a first electron transport layer ETL1.

The hole injection layer HIL is disposed on the first electrode 400 and the bank 450 of FIG. 1 described above, and can be formed to be continuous without being disconnected in red, green, and blue sub-pixels (R sub-pixels, G sub-pixels, and B sub-pixels).

The first hole transport layer HTL1 is disposed on the hole injection layer HIL, and can be formed to be continuous without being disconnected in red, green, and blue sub-pixels (R sub-pixels, G sub-pixels, and B sub-pixels).

The first light emitting layers R-EML1, G-EML1, and B-EML1 are disposed on the first hole transport layer HTL1.

The first light emitting layers R-EML1, G-EML1, and B-EML1 include a first red light emitting layer R-EML1 disposed in the red sub-pixel, a first green light emitting layer G-EML1 disposed in the green sub-pixel, and a first blue light emitting layer B-EML1 disposed in the blue sub-pixel.

The first red light emitting layer R-EML1, the first green light emitting layer G-EML1, and the first blue light emitting layer B-EML1 may not overlap each other, but are not limited thereto. In addition, the first red light emitting layer R-EML1, the first green light emitting layer G-EML1, and the first blue light emitting layer B-EML1 can be formed not to be in contact with each other.

The first electron transport layer ETL1 is disposed on the first light emitting layers R-EML1, G-EML1, and B-EML1, and can be formed to be continuous without being disconnected in red, green, and blue sub-pixels (R sub-pixels, G sub-pixels, and B sub-pixels).

The first stack (1^{st} Stack) can further include a hole blocking layer HBL disposed between the first light emitting layer R-EML1, G-EML1, and B-EML1 and the first electron transport layer ETL1.

The second stack (2^{nd} Stack) includes a second hole transport layer HTL2, third hole transport layers HTL3-1, HTL3-2, and HTL3-3, second light emitting layers R-EML2, G-EML2, B-EML2, a second electron transport layer ETL2, and an electron injection layer EIL.

The second hole transport layer HTL2 is disposed on the charge generation layer CGL. More particularly, the second hole transport layer HTL2 is disposed on a P-type charge generation layers P-CGL. Further, the second hole transport layer HTL2 can be formed to be continuous without being disconnected in red, green, and blue sub-pixels (R sub-pixels, G sub-pixels, and B sub-pixels). The second hole transport layer HTL2 can be formed of the same material as the first hole transport layer HTL1, but is not limited thereto.

The third hole transport layers HTL3-1, HTL3-2, and HTL3-3 are disposed on the second hole transport layer HTL2.

The third hole transport layers HTL3-1, HTL3-2, and HTL3-3 include a 3-1st hole transport layer HTL3-1 disposed in the red sub-pixel(R sub-pixel), a 3-2nd hole transport layer HTL3-2 disposed in the green sub-pixel(G sub-pixel), and a 3-3rd hole transport layer HTL3-3 disposed in the blue sub-pixel(B sub-pixel).

The third hole transport layers HTL3-1, HTL3-2, and HTL3-3 are formed to obtain a microcavity effect for each sub-pixel (R sub-pixel, G sub-pixel, and B sub-pixel). The 3-1st hole transport layer HTL3-1 is for obtaining a microcavity effect in the red sub-pixel (R sub-pixel), and the 3-2nd hole transport layer HTL3-2 is for obtaining a microcavity effect in the green sub-pixel (G sub-pixel), and the 3-3rd hole transport layer HTL3-3 is for obtaining a microcavity effect in the blue sub-pixel (B sub-pixel).

Considering that red is a longer wavelength than green and green is a longer wavelength than blue, a thickness of the 3-1st hole transport layer HTL3-1 can be greater than a thickness of the 3-2nd hole transport layer HTL3-2, and the thickness of the 3-2nd hole transport layer HTL3-2 can be greater than a thickness of the 3-3rd hole transport layer HTL3-3. In the blue sub-pixel(B sub-pixel), a micro-cavity effect can be obtained by the second hole transport layer HTL2, and in this case, the 3-3rd hole transport layer HTL3-3 can be omitted.

The third hole transport layers HTL3-1, HTL3-2, and HTL3-3 can be formed of the same material as the second hole transport layer HTL2 or the first hole transport layer HTL1, but are not limited thereto. The 3-1st hole transport layer HTL3-1, the 3-2nd hole transport layer HTL3-2, and the 3-3rd hole transport layer HTL3-3 can be formed of the same material, but are not limited thereto.

The 3-1st hole transport layer HTL3-1, the 3-2nd hole transport layer HTL3-2, and the 3-3rd hole transport layer HTL3-3 may not overlap each other. In addition, the 3-1st hole transport layer HTL3-1, the 3-2nd hole transport layer HTL3-2, and the 3-3rd hole transport layer HTL3-3 can be formed not to be in contact with each other.

In some cases, the third hole transport layers HTL3-1, HTL3-2, and HTL3-3 may not be formed in the second stack (2^{nd} Stack), but can be formed in the first stack (1^{st} Stack). Specifically, the third hole transport layers HTL3-1, HTL3-2, and HTL3-3 may not be formed between the second hole transport layer HTL2 and the second light emitting layers R-EML2, G-EML2, and B-EML2, but can be formed between the first hole transport layer HTL1 and the first light emitting layers R-EML1, G-EML1, and B-EML1.

The second light emitting layers R-EML2, G-EML2, and B-EML2 are disposed on the third hole transport layers HTL3-1, HTL3-2, and HTL3-3.

The second light emitting layers R-EML2, G-EML2, and B-EML2 include the second red light emitting layer R-EML2 disposed in the red sub-pixel (R sub-pixel), the second green light emitting layer G-EML2 disposed in the green sub-pixel (G sub-pixel), and the second blue light emitting layer B-EML2 disposed in the blue sub-pixel (B sub-pixel).

The second red light emitting layer R-EML2, the second green light emitting layer G-EML2, and the second blue light emitting layer B-EML2 may not overlap each other, but are not limited thereto. The second red light emitting layer R-EML2, the second green light emitting layer G-EML2, and the second blue light emitting layer B-EML2 can be formed not to be in contact with each other.

The second red light emitting layer R-EML2 can be formed of the same material as the first red light emitting layer R-EML1, but is not limited thereto. The second green light emitting layer G-EML2 can be formed of the same material as the first green light emitting layer G-EML1, but is not limited thereto. The second blue light emitting layer B-EML2 can be formed of the same material as the first blue light emitting layer B-EML1, but is not limited thereto.

The second electron transport layer ETL2 is disposed on the second light emitting layers R-EML2, G-EML2, and B-EML2, and can be formed to be continuous without being disconnected in red, green, and blue sub-pixels (R sub-pixels, G sub-pixels, and B sub-pixels).

The second stack (2^{nd} Stack) can further include a hole blocking layer HBL disposed between the second light emitting layers R-EML2, G-EML2, and B-EML2 and the second electron transport layer ETL2.

The electron injection layer EIL is disposed on the second electron transport layer ETL2, and can be formed to be continuous without being disconnected in red, green, and blue sub-pixels (R sub-pixels, G sub-pixels, and B sub-pixels).

According to an embodiment of the present disclosure, the first light emitting layers R-EML1, G-EML1, and B-EML1 include the first red light emitting layer R-EML1, the first green light emitting layer G-EML1, and the first blue light emitting layer B-EML1, and the second light emitting layer R-EML2, G-EML2, and B-EML2 include the second red light emitting layer R-EML2, the second green light emitting layer G-EML2, and the second blue light emitting layer B-EML2. Accordingly, without a separate color filter, red light can be emitted from the red sub-pixel (R sub-pixel), green light can be emitted from the green sub-pixel (G sub-pixel), and blue light can be emitted from the blue sub-pixel (B sub-pixel).

The charge generation layer CGL is disposed between the first stack (1^{st} Stack) and the second stack (2^{nd} Stack). The charge generation layer CGL can be disposed between the first electron transport layer ETL1 and the second hole transport layer HTL2.

The charge generation layer CGL includes an N-type charge generation layer N-CGL and a P-type charge generation layers P-CGL.

The N-type charge generation layer N-CGL supplies electrons to the first stack (1^{st} Stack) and the P-type charge generation layers P-CGL supply holes to the second stack (2^{nd} Stack).

The N-type charge generation layer N-CGL is disposed on the first electron transport layer ETL1, and can be formed to be continuous without being disconnected in red, green, and blue sub-pixels (R sub-pixel, G sub-pixel, B sub-pixel).

The P-type charge generation layers P-CGL is disposed on the N-type charge generation layer N-CGL, and can be formed to be continuous without being disconnected in red, green, and blue sub-pixels (R sub-pixel, G sub-pixel, B sub-pixel).

The present disclosure can further include an additional charge generation layer and a third stack on the second stack (2^{nd} Stack).

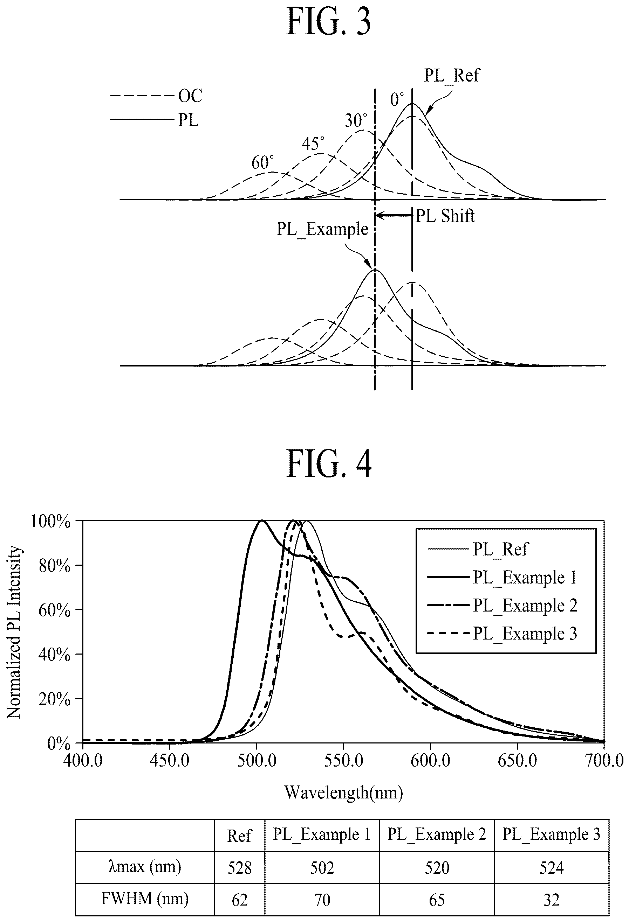

FIG. 3 is a graph showing an electroluminescence (EL) spectrum according to an embodiment of the present disclosure.

In general, a product of a PL (photoluminescence) spectrum of the light emitted from the light emitting layer and an OC (out-coupling) curve of set in consideration a microcavity characteristics becomes an electroluminescence (EL) spectrum of the light emitted finally. Therefore, as an overlapping area between the PL spectrum and the OC curve increases, color reproducibility and light efficiency can be improved.

As can be seen from FIG. 3, if the viewing angle increases from a front viewing angle (0°) to a side viewing angle (30°, 45°, 60°), the PL spectrum does not change, but the OC curve is shifted toward a short wavelength and a peak wavelength is also reduced, which can reduce color reproducibility and light efficiency.

In the case of the comparative example, a overlapping area between the PL spectrum (PL_Ref) and the OC curve is set to be the largest at the front viewing angle (0°), and accordingly, color reproducibility and light efficiency are excellent at the front viewing angle (0°), but color reproducibility and light efficiency are relatively low at the side viewing angle (30°, 45°, 60°), especially when the viewing angle is large, such as the 60° viewing angle, there is little overlapping area between the PL spectrum (PL_Ref) and the OC curve, so a desired color is not emitted and the light efficiency is very low.

Accordingly, in an embodiment of the present disclosure, a PL spectrum (PL_Example) is set to be shifted toward the short wavelength compared to the PL spectrum (PL_Ref) of the comparative example. Accordingly, according to an embodiment of the present disclosure, an overlapping area between the PL spectrum (PL_Example) and the OC curve can be the largest at the side viewing angle, for example, between 0° and 30°. For example, the overlapping area between the PL spectrum (PL_Example) and the OC curve at a side viewing angle, for example, between 0° and 30°, can be larger than an overlapping area between the PL spectrum (PL_Example) and the OC curve at the front viewing angle (0°).

Accordingly, in the case of an embodiment of the present disclosure, color reproducibility and light efficiency are slightly reduced at the front viewing angle (0°) compared to the comparative example, but color reproducibility and light efficiency can be relatively improved at the side viewing angle (30°, 45°, 60°). Accordingly, even when the viewing angle is increased, such as a viewing angle of 60°, the overlapping area between the PL spectrum (PL_Example) and the OC curve can exist, so a relatively desired color can be emitted.

Therefore, an embodiment of the present disclosure can be suitable for display devices such as rollable, bendable, and edge bending that require excellent characteristics at the side viewing angle.

FIG. 4 is a graph showing a photoluminescence (PL) spectrum according to various embodiments of the present disclosure. For example, FIG. 4 shows a spectrum of green light emitted from a green light emitting layer according to various embodiments of the present disclosure.

As shown in FIG. 4, the PL spectrum (PL_Ref) according to the comparative example and the PL spectrum (PL_Example 1, PL_Example 2, and PL_Example 3) according to first to third embodiments all have a first peak and a second peak positioned toward a long wavelength while being weaker in intensity than the first peak. The peak wavelength (λmax) described below means a wavelength of the first peak.

In the case of the PL spectrum (PL_Ref) according to the comparative example, the peak wavelength (λmax) is 528 nm and a full width at half maximum (FWHM) is 62 nm.

In the case of the PL spectrum (PL_Example 1) according to the first embodiment, the peak wavelength (λmax) is 502 nm and a full width at half maximum (FWHM) is 70 nm.

In the case of the PL spectrum (PL_Example 2) according to the second embodiment, the peak wavelength (λmax) is 520 nm and a full width at half maximum (FWHM) is 65 nm.

In the case of the PL spectrum (PL_Example 3) according to the third embodiment, the peak wavelength (λmax) is 524 nm and a full width at half maximum (FWHM) is 32 nm.

Therefore, the PL spectrum (PL_Example 1, PL_Example 2, and PL_Example 3) according to the first to third embodiments are shifted toward the short wavelength compared to the PL spectrum (PL_Ref) according to the comparative example.

At this time, among the PL spectrum (PL_Example 1, PL_Example 2, and PL_Example 3) according to the first to third embodiments, the PL spectrum (PL_Example 1) according to the first embodiment is shifted toward the short wavelength the most, and the PL spectrum (PL_Example 3) according to the third embodiment is shifted toward the short wavelength the least.

In addition, it can be seen that among the PL spectrum (PL_Example 1, PL_Example 2, and PL_Example 3) according to the first to third embodiments, the PL spectrum (PL_Example 1) according to the first embodiment has the largest FWHM and PL spectrum (PL_Example 3) according to the third embodiment has the smallest FWHM.

In addition, it can be seen that among the PL spectrum (PL_Example 1, PL_Example 2, and PL_Example 3) according to the first to third embodiments, an intensity of the second peak of the PL spectrum (PL_Example 1) according to the first embodiment is the largest, and an intensity of the second peak of the PL spectrum (PL_Example 3) according to the third embodiment is the smallest. For example, in the case of the PL spectrum (PL_Example 1) according to the first embodiment and the PL spectrum (PL_Example 2) according to the second embodiment, the intensity of the second peak is greater than 0.5 times the intensity of the first peak, and in the case of the PL spectrum (PL_Example 3) according to the third embodiment, the intensity of the second peak is less than 0.5 times the intensity of the first peak, and more accurately, 0.46 times.

Hereinafter, color reproducibility and light efficiency of each light having PL spectrum (PL_Example 1, PL_Example 2, and PL_Example 3) according to the first to third embodiments will be described.

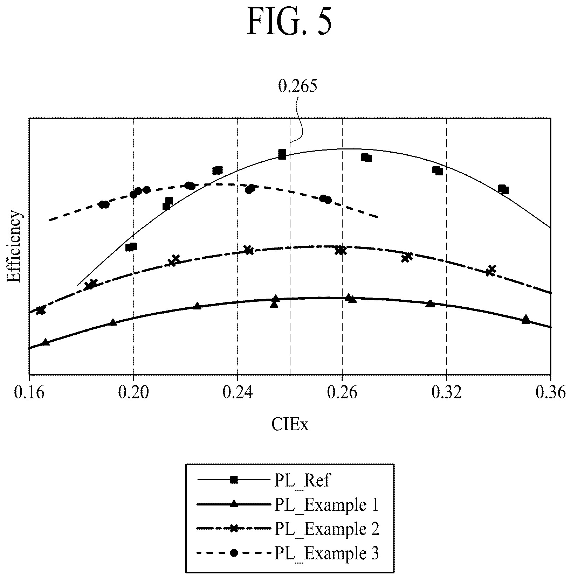

FIG. 5 is a graph showing a color coordinate value and light efficiency of light according to various embodiments of the present disclosure. For example, FIG. 5 shows color coordinates and light efficiency changes according to change of OC curves of light with PL spectrum (PL_Ref) according to the comparative example shown in FIG. 4 and PL spectrum (PL_Example 1, PL_Example 2, and PL_Example 3) according to the first to third embodiments.

As can be seen from FIG. 5, as the OC curve of the light emitting unit changes, for example, as the hole transport layer in the light emitting unit is changed from thin to thick, in each of the PL spectrum (PL_Ref) according to the comparative example and the PL spectrum (PL_Example 1, PL_Example 2, and PL_Example 3) according to the first to third embodiments, the color coordinate (CIEx) value gradually increases, and the light efficiency gradually increases and then gradually decreases again.

In the case of green light, a desired green light can be emitted only when the color coordinate (CIEx) value is less than 0.265, and in the PL spectrum (PL_Ref) according to the comparative example, the color coordinate (CIEx) value in the case of the best light efficiency is greater than 0.28, so it is difficult to emit the desired green light in the case of the PL spectrum (PL_Ref) according to the comparative example.

In the PL spectrum (PL_Example 1 and PL_Example 2) according to the first and second embodiments, since the color coordinate (CIEx) value in the case of the best light efficiency is less than 0.28 but is greater than 0.265, it may not be easy to emit desired green light in the PL spectrum (PL_Example 1 and PL_Example 2) according to the first and second embodiments.

On the other hand, in the PL spectrum (PL_Example 3) according to the third embodiment, since the color coordinate (CIEx) value in the case of the best light efficiency is less than 0.265, the PL spectrum (PL_Example 3) according to the third embodiment is easy to emit desired green light. In addition, it can be seen that the light efficiency of the PL spectrum (PL_Example 3) according to the third embodiment is superior to the light efficiency of the PL spectrum (PL_Example 1 and PL_Example 2) according to the first and second embodiments.

Therefore, it can be seen that when the green light emitting layer is configured to emit green light having the PL spectrum (PL_Example 3) according to the third embodiment, the desired green light with the color coordinate (CIEx) value less than 0.265 can be emitted and the light efficiency of the emitted light can be improved.

In order to emit light having the PL spectrum (PL_Example 3) according to the third embodiment in the green light emitting layer, the green light emitting layer can include a host material and a dopant material, and the dopant material can include a metal complex, for example, an iridium (Ir) or platinum (Pt) metal complex, but is not limited thereto.

Based on the above results, the peak wavelength (λmax) of the PL spectrum of green light according to an embodiment of the present disclosure can be equal to or greater than 520 nm, which is the peak wavelength (λmax) of the PL spectrum (PL_Example 2) according to the second embodiment, and can be less than 528 nm, which is the peak wavelength (λmax) of the PL spectrum (PL_Ref) according to the comparative example.

More preferably, the peak wavelength (λmax) of the PL spectrum of green light according to an embodiment of the present disclosure can be equal to or greater than 524 nm, which is the peak wavelength (λmax) of the PL spectrum (PL_Example 3) according to the third embodiment and can be less than 528 nm.

The PL spectrum of green light according to an embodiment of the present disclosure can have the first peak and the second peak positioned at the long wavelength side while being weaker than the first peak, and in this case, the intensity of the second peak can be less than 0.5 times the intensity of the first peak. The PL spectrum of green light according to an embodiment of the present disclosure can have the first peak and the second peak positioned at the long wavelength side while being weaker than the first peak, and in this case, the intensity of the second peak can be 0.46 times or less than 0.46 times the intensity of the first peak. The PL spectrum of green light according to an embodiment of the present disclosure can have only the first peak and may not have the second peak, and in this case, it can be more advantageous in terms of color reproducibility.

A full width at half maximum (FWHM) of the PL spectrum of green light according to an embodiment of the present disclosure can be less than 62 nm, which is a FWHM of the PL spectrum (PL_Ref) according to the comparative example. More preferably, the FWHM of the PL spectrum of green light according to an embodiment of the present disclosure can be equal to or greater than 32 nm which is the FWHM of the PL spectrum (PL_Example 3) according to the third embodiment, and can be less than 62 nm, but is not limited thereto.

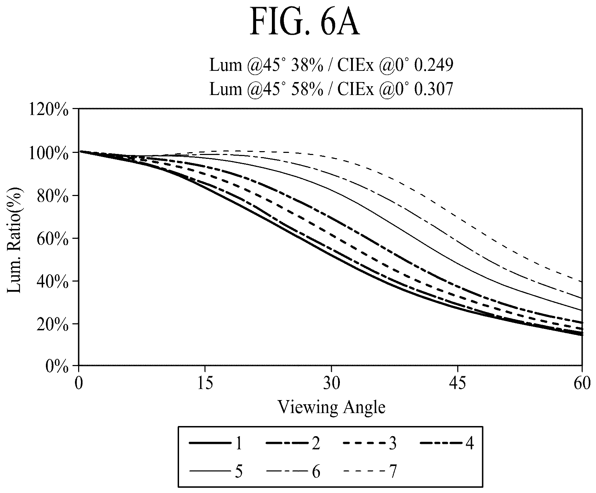

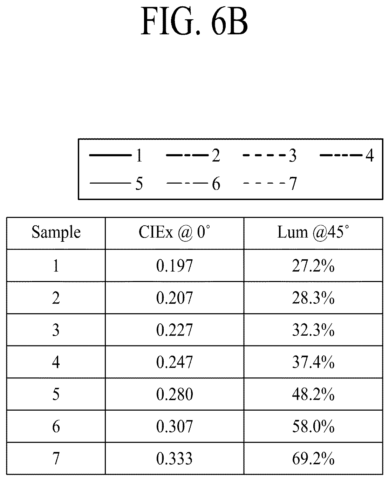

FIG. 6A is a graph showing a luminance change according to a viewing angle change of light having a PL spectrum (PL_Ref) according to a comparative example, and FIG. 6B is a table showing a color coordinate (CIEx @0°) at a front viewing angle (0°) and a luminance ratio (Lum@45°) at a side viewing angle (45°) of light having a PL spectrum (PL_Ref) according to the comparative example.

In FIGS. 6A and 6B, Samples 1 to 7 are obtained by gradually changing a thickness of the hole transport layer from an optimum efficiency thickness to a thin thickness in order to change the OC curve while emitting light having the PL spectrum (PL_Ref) according to the comparative example.

As can be seen from FIG. 6A, as the viewing angle increases, a luminance of all samples 1 to 7 tends to decrease overall.

As can be seen from FIG. 6B, samples with color coordinates (CIEx @0°) less than 0.265 at the front viewing angle (0°) are sample 1 to sample 4, and the luminance (Lum@45°) at their side viewing angle (45°) is less than 40%.

In particular, in the comparative example, if the color coordinate (CIEx @0°) is 0.249 at the front viewing angle (0°) that can satisfy color reproducibility, the luminance (Lum@45°) at the side viewing angle (45°) is not good at 38%, and if the luminance (Lum@45°) is 58% at the side viewing angle (45°) with excellent light efficiency, the color coordinate (CIEx @0°) is 0.307 at the front viewing angle (0°), indicating that color reproducibility is very poor.

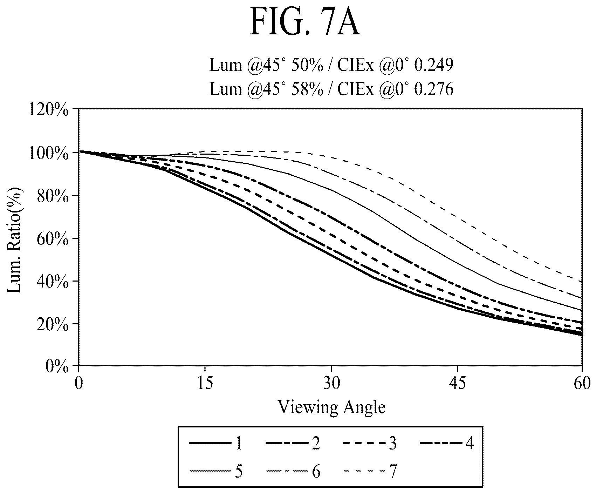

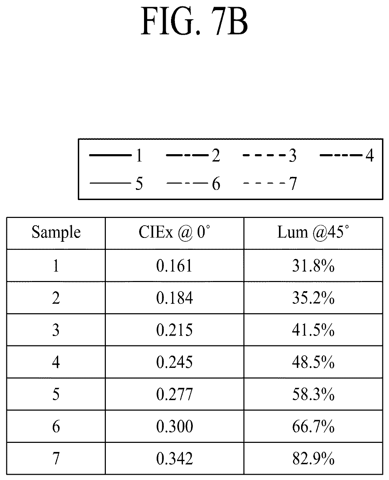

FIG. 7A is a graph showing a luminance change according to a viewing angle change of light having a PL spectrum (PL_Example 1) according to a first embodiment, and FIG. 7B is a table showing a color coordinate (CIEx @0°) at a front viewing angle (0°) and a luminance ratio (Lum@45°) at a side viewing angle (45°) of light having a PL spectrum (PL_Example 1) according to the first embodiment.

In FIGS. 7A and 7B, Samples 1 to 7 are obtained by gradually changing a thickness of the hole transport layer from an optimum efficiency thickness to a thin thickness in order to change the OC curve while emitting light having the PL spectrum (PL_Example 1) according to the first embodiment.

As can be seen from FIG. 7A, as the viewing angle increases, a luminance of all samples 1 to 7 tends to decrease overall.

As can be seen from FIG. 7B, samples with color coordinates (CIEx @0°) less than 0.265 at the front viewing angle (0°) are sample 1 to sample 4, and it can be seen that the luminance (Lum@45°) at their side viewing angle (45°) is superior to the case of the above-described comparative example.

In particular, in the case of Example 1, when the color coordinate (CIEx @0°) is 0.249 at the front viewing angle (0°) that can satisfy color reproducibility, the luminance (Lum@45°) at the side viewing angle (45°) is good at 50%, but when the luminance (Lum@45°) is 58% at the side viewing angle (45°) with excellent light efficiency, the color coordinate (CIEx @0°) value at the front viewing angle (0°) is 0.276, indicating that color reproducibility problems can occur.

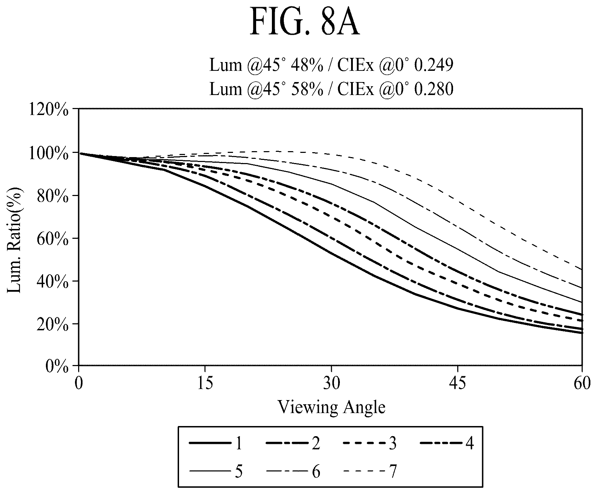

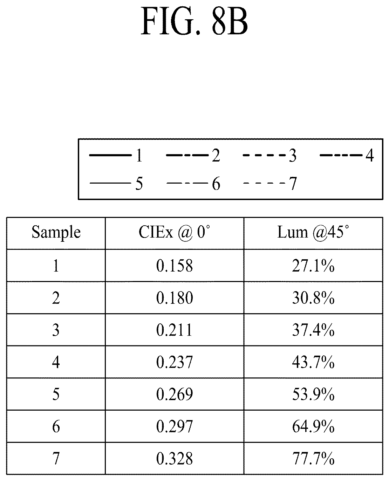

FIG. 8A is a graph showing a luminance change according to a viewing angle change of light having a PL spectrum (PL_Example 2) according to a second embodiment, and FIG. 8B is a table showing a color coordinate (CIEx @0°) at a front viewing angle (0°) and a luminance ratio (Lum@45°) at a side viewing angle (45°) of light having a PL spectrum (PL_Example 2) according to the second embodiment.

In FIGS. 8A and 8B, Samples 1 to 7 are obtained by gradually changing a thickness of the hole transport layer from an optimum efficiency thickness to a thin thickness in order to change the OC curve while emitting light having the PL spectrum (PL_Example 2) according to the second embodiment.

As can be seen from FIG. 8A, as the viewing angle increases, a luminance of all samples 1 to 7 tends to decrease overall.

As can be seen from FIG. 8B, samples with color coordinates (CIEx @0°) less than 0.265 at the front viewing angle (0°) are sample 1 to sample 4, and it can be seen that the luminance (Lum@45°) at their side viewing angle (45°) is superior to the case of the above-described comparative example.

In particular, in the case of Example 2, when the color coordinate (CIEx @0°) is 0.249 at the front viewing angle (0°) that can satisfy color reproducibility, the luminance (Lum@45°) at the side viewing angle (45°) is good at 48%, but when the luminance (Lum@45°) is 58% at the side viewing angle (45°) with excellent light efficiency, the color coordinate (CIEx @0°) value at the front viewing angle (0°) is 0.280, indicating that color reproducibility problems can occur.

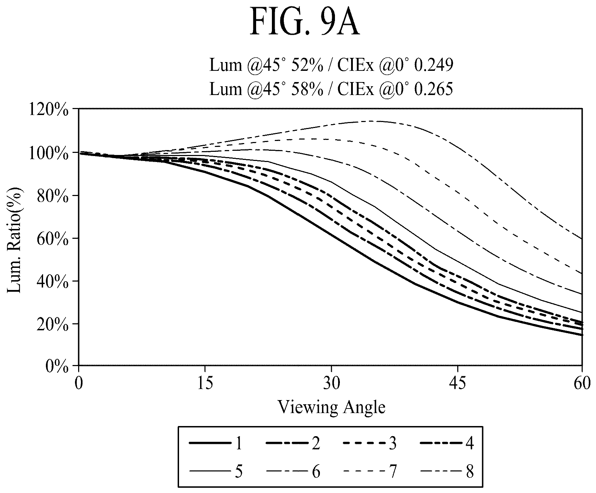

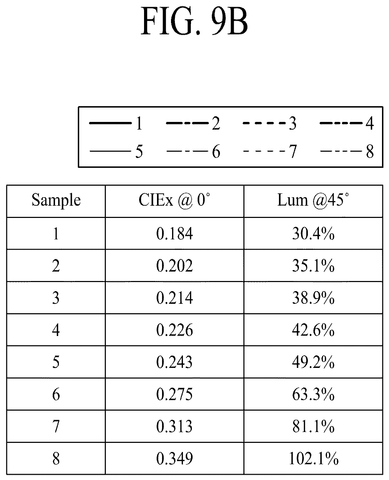

FIG. 9A is a graph showing a luminance change according to a viewing angle change of light having a PL spectrum (PL_Example 3) according to a third embodiment, and FIG. 9B is a table showing a color coordinate (CIEx @0°) at a front viewing angle (0°) and a luminance ratio (Lum@45°) at a side viewing angle (45°) of light having a PL spectrum (PL_Example 3) according to the third embodiment.

In FIGS. 9A and 9B, Samples 1 to 7 are obtained by gradually changing a thickness of the hole transport layer from an optimum efficiency thickness to a thin thickness in order to change the OC curve while emitting light having the PL spectrum (PL_Example 3) according to the third embodiment.

As can be seen from FIG. 9A, sample 1 to sample 6 have a tendency to decrease luminance as the viewing angle increases, but sample 7 and sample 8 have a tendency to increase luminance and then decrease again at a viewing angle greater than about 30°.

As can be seen from FIG. 9B, samples with color coordinates (CIEx @0°) less than 0.265 at the front viewing angle (0°) are sample 1 to sample 5, and it can be seen that the luminance (Lum@45°) at their side viewing angle (45°) is superior to the case of the above-described comparative example.

In particular, in the case of Example 3, when the color coordinate (CIEx @0°) is 0.249 at the front viewing angle (0°) that can satisfy color reproducibility, the luminance (Lum@45°) is the best at 52% at the side viewing angle (45°), and when the luminance (Lum@45°) is 58% at the side viewing angle (45°) with excellent light efficiency, the color coordinate (CIEx @0°) is 0.265 at the front viewing angle (0°) and there is no problem with color reproducibility.

Therefore, from FIGS. 6A, 6B, 7A, 7B, 8A, 8B, and 9A and 9B, it can be seen that the case of emitting light with the PL spectrum (PL_Example 3) according to the third embodiment is superior in terms of light efficiency and color reproducibility compared to the case of emitting light with the PL spectrum (PL_Example 1 and PL_Example 2) according to the first and second embodiments.

In addition, as shown in FIGS. 9A and 9B, even if light with a PL spectrum (PL_Example 3) according to the third embodiment is used, the color coordinates and light efficiency vary according to the change of the OC curve, so it is necessary to optimize the OC curve.

According to an embodiment of the present disclosure, the peak wavelength at the front viewing angle of the OC curve of the light emitting unit can be longer wavelength than the peak wavelength of the PL spectrum of the light emitting layer, and the peak wavelength at the 45° side viewing angle of the OC curve of the light emitting unit can be shorter than the peak wavelength of the PL spectrum of the light emitting layer.

Hereinafter, an optimization of the OC curve will be described.

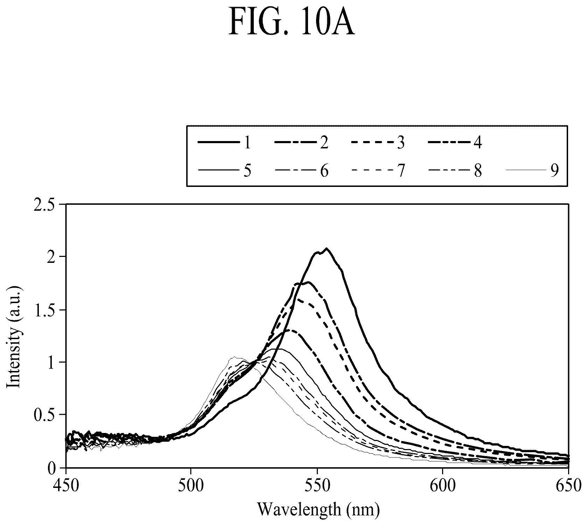

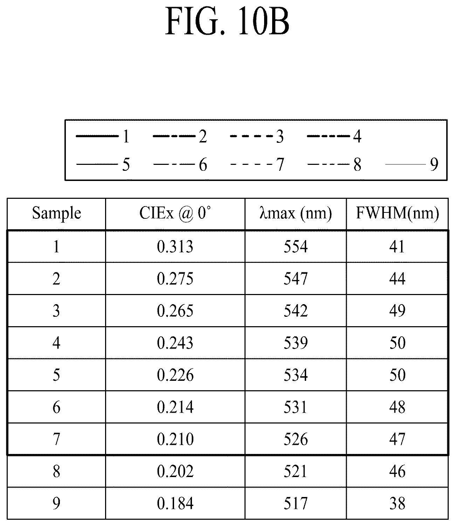

FIG. 10A is a graph showing an OC curve in a green wavelength band according to various examples at a front viewing angle, and FIG. 10B is a peak wavelength and a FWHM of various OC curve and a color coordinate (CIEx @0°) of emission light in a green wavelength band of FIG. 10A. In FIG. 10B, the color coordinate (CIEx @0°) is a color coordinate value at a front viewing angle of the emitted light obtained by applying the PL spectrum (PL_Example 3) according to the third embodiment and various OC curves of FIG. 10A.

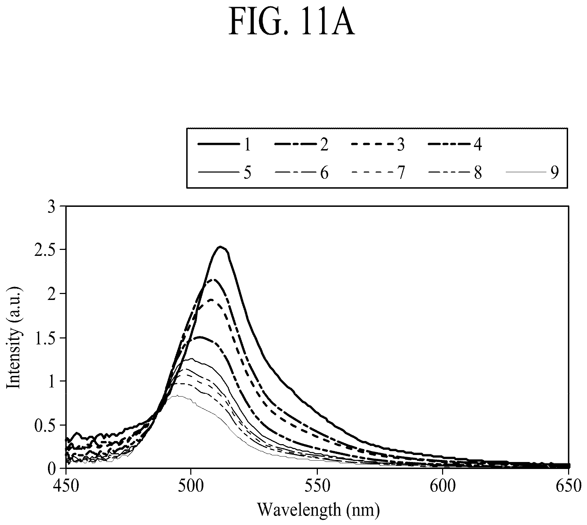

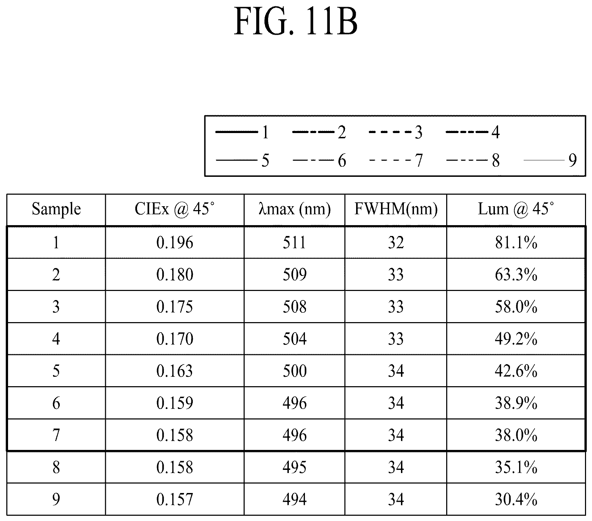

FIG. 11A is a graph showing an OC curve in a green wavelength band according to various examples at a side viewing angle (45°), and FIG. 11B is a peak wavelength and a FWHM of various OC curve and a color coordinate (CIEx @45°) of emission light in a green wavelength band of FIG. 11A. In FIG. 11B, the color coordinate (CIEx @45°) is a color coordinate value at a side viewing angle (45°) of the emitted light obtained by applying the PL spectrum (PL_Example 3) according to the third embodiment and various OC curves of FIG. 11A.

FIGS. 10A, 10B, 11A, and 11B show peak wavelengths, FWHMs, and color coordinate values at the front and side viewing angles (45°) for OC curves of samples 1 to 9.

As can be seen from FIGS. 10A, 10B, 11A, and 11B, the peak wavelength moves toward the short wavelength and the light intensity decreases from sample 1 to sample 9 in both the front viewing angle and the side viewing angle (45°). In addition, it can be seen that the color coordinate value decreases from sample 1 to sample 9 in both the front viewing angle and the side viewing angle (45°).

In terms of color reproducibility, considering that the color coordinate value of 0.265 or less can be desirable to emit the desired green light, sample 3 to sample 9 are advantageous at the front viewing angle, but sample 1 to sample 9 are all desirable at the side viewing angle (45°).

In terms of light intensity, sample 1 is the most advantageous and sample 9 is the most disadvantageous, and in particular, sample 9 and sample 8 are less than 38% at the side viewing angle (45°), so there is a disadvantage that the luminance of emitted light is low. The luminance (Lum@45°) of samples 1 to 7 is good in the range of 81.1% to 38%.

From the above results, especially considering color reproducibility and light intensity at the side viewing angle (45°), the OC curve according to an embodiment of the present disclosure can be preferable as an OC curve according to sample 1 to sample 7.

Therefore, as shown in FIG. 10B, in the case of an OC curve according to an embodiment of the present disclosure, the peak wavelength (λmax) at the front viewing angle can be 526 nm or more and 554 nm or less, and the FWHM at the front viewing angle can be 41 nm or more and 50 nm or less.

In addition, as shown in FIG. 11B, in the case of an OC curve according to an embodiment of the present disclosure, the peak wavelength (λmax) at the side viewing angle (45°) can be 496 nm or more and 511 nm or less, and the FWHM at the side viewing angle (45°) can be 32 nm or more and 34 nm or less.

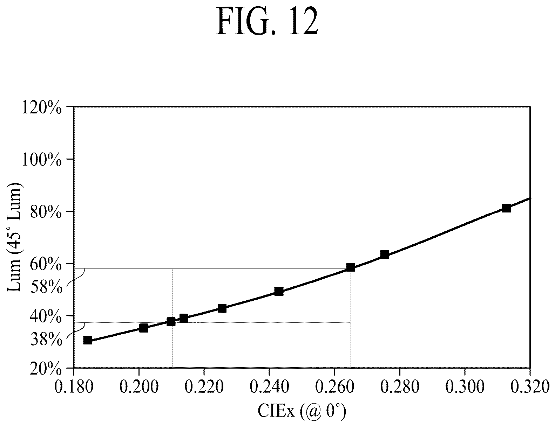

FIG. 12 is a graph showing color coordinate values and luminance rates of emitted light by applying a PL spectrum and various OC curves according to an embodiment of the present disclosure.

In FIG. 12, the PL spectrum is the PL spectrum (PL_Example 3) according to the third embodiment described above, various OC curves are OC curves according to samples 1 to 9 of FIGS. 10A, 10B, 11A, and 11B described above, and the color coordinate (CIEx @0°) value is the color coordinate at the front viewing angle, and the luminance (Lum@45°) is the luminance at the 45° viewing angle.

As can be seen from FIG. 12, when the color coordinate value increases, the luminance ratio increases and when the color coordinate value decreases, the luminance ratio tends to decrease.

Specifically, it is difficult to obtain emitted light with a luminance of 60% or more at the 45° viewing angle while having a color coordinate value of 0.265 or less at a front viewing angle.

According to another embodiment of the present disclosure, emitted light having a color coordinate value of 0.265 or less at a front viewing angle and a luminance of 38% or more at a 45° viewing angle can be used as green light, which can correspond to the OC curve according to samples 3 to 7 described above.

Therefore, referring to FIG. 10B, in the case of an OC curve according to another embodiment of the present disclosure, the peak wavelength (λmax) at the front viewing angle can be 526 nm or more and 542 nm or less, and the FWHM at the front viewing angle can be 47 nm or more and 50 nm or less.

In addition, referring to FIG. 11B, in the case of an OC curve according to another embodiment of the present disclosure, the peak wavelength (λmax) can be 496 nm or more and 508 nm or less at the side viewing angle (45°), and the FWHM can be 33 nm or more and 34 nm or less at the side viewing angle (45°).

In the electroluminescent display device according to another embodiment of the present disclosure, a luminance of a light emitted from the light emitting unit is 38% to 58% at the 45° side viewing angle.

The following numbered examples pertain to embodiments of the present disclosure.

Example 1: An electroluminescent display device comprising: a substrate; a first electrode on the substrate; a light emitting unit including a light emitting layer disposed on the first electrode; and a second electrode on the light emitting unit, wherein a peak wavelength of a photoluminescence (PL) spectrum of the light emitting layer is shorter than a peak wavelength of an out-coupling (OC) curve of the light emitting unit at a front viewing angle, and is longer than a peak wavelength of the OC curve of the light emitting unit at a 45° side viewing angle.

Example 2: The electroluminescent display device of Example 1, wherein the PL spectrum of the light emitting layer has the peak wavelength equal to or greater than 520 nm and less than 528 nm.

Example 3: The electroluminescent display device of Example 1, wherein the PL spectrum of the light emitting layer has the peak wavelength equal to or greater than 524 nm and less than 528 nm.

Example 4: The electroluminescent display device of any of Examples 1 to 3, wherein the PL spectrum of the light emitting layer has a first peak and a second peak positioned at a longer wavelength than the first peak, and an intensity of the second peak is less than 0.5 times an intensity of the first peak.

Example 5: The electroluminescent display device of any of Examples 1 to 3, wherein the PL spectrum of the light emitting layer has a first peak and a second peak positioned at a longer wavelength than the first peak, and an intensity of the second peak is 0.46 times or less than 0.46 times an intensity of the first peak.

Example 6: The electroluminescent display device of any of Examples 1 to 5, wherein the PL spectrum of the light emitting layer has a full width at half maximum (FWHM) equal to or greater than 32 nm and less than 62 nm.

Example 7: The electroluminescent display device of any of Examples 1 to 6, wherein the OC curve of the light emitting unit has the peak wavelength ranging from 526 nm to 554 nm at the front viewing angle.

Example 8: The electroluminescent display device of Example 7, wherein the OC curve of the light emitting unit has a full width at half maximum (FWHM) of 41 nm or more and 50 nm or less at the front viewing angle.

Example 9: The electroluminescent display device of any of Examples 1 to 8, wherein the OC curve of the light emitting unit has the peak wavelength ranging from 496 nm to 511 nm at the 45° side viewing angle.

Example 10: The electroluminescent display device of Example 9, wherein the OC curve of the light emitting unit has a full width at half maximum (FWHM) of 32 nm or more and 34 nm or less at the 45° side viewing angle.

Example 11: The electroluminescent display device of any of Examples 1 to 6, wherein the OC curve of the light emitting unit has the peak wavelength ranging from 526 nm to 542 nm at the front viewing angle.

Example 12: The electroluminescent display device of Example 11, wherein the OC curve of the light emitting unit has a full width at half maximum (FWHM) of 47 nm or more and 50 nm or less at the front viewing angle.

Example 13: The electroluminescent display device of any of Examples 1 to 6, 11, or 12, wherein the OC curve of the light emitting unit has the peak wavelength ranging from 496 nm to 508 nm at the 45° side viewing angle.

Example 14: The electroluminescent display device of Example 13, wherein the OC curve of the light emitting unit has a full width at half maximum (FWHM) of 33 nm or more and 34 nm or less at the 45° side viewing angle.

Example 15: The electroluminescent display device of Example 13 or 14, wherein a luminance of a light emitted from the light emitting unit is 38% to 58% at the 45° side viewing angle.

Example 16: The electroluminescent display device of any of Examples 1 to 15, wherein the light emitting layer is a green light emitting layer disposed in a green sub-pixel, the green light emitting layer includes a host material and a dopant material, and the dopant material includes an iridium or platinum metal complex.

Example 17: An electroluminescent display device comprising: a first electrode on a substrate; a light emitting unit including a light emitting layer disposed on the first electrode; and a second electrode on the light emitting unit, wherein an overlapping area between a photoluminescence (PL) spectrum of the light emitting layer and an out-coupling (OC) curve of the light emitting unit at one side viewing angle between 0° and 30° is larger than an overlapping area between the PL spectrum of the light emitting layer and the OC curve of the light emitting unit at a front viewing angle.

Example 18: The electroluminescent display device of Example 17, wherein the PL spectrum of the light emitting layer has a peak wavelength equal to or greater than 520 nm and less than 528 nm, and the OC curve of the light emitting unit has a peak wavelength ranging from 526 nm to 554 nm at the front viewing angle.

Example 19: The electroluminescent display device of Example 17 or 18, wherein the PL spectrum of the light emitting layer has a first peak and a second peak positioned at a longer wavelength than the first peak, and an intensity of the second peak is less than 0.5 times an intensity of the first peak.

Example 20: The electroluminescent display device of any of Examples 17 to 19, wherein the PL spectrum of the light emitting layer has a full width at half maximum (FWHM) equal to or greater than 32 nm and less than 62 nm, and the OC curve of the light emitting unit has a FWHM of 41 nm or more and 50 nm or less at the front viewing angle.

## Claims

1. An electroluminescent display device comprising:
a substrate (100);
a first electrode (400) on the substrate (100);
a light emitting unit (500) including a light emitting layer disposed on the first electrode (400); and
a second electrode (600) on the light emitting unit (500),
wherein a peak wavelength of a photoluminescence (PL) spectrum of the light emitting layer is shorter than a peak wavelength of an out-coupling (OC) curve of the light emitting unit (500) at a front viewing angle, and is longer than a peak wavelength of the OC curve of the light emitting unit (500) at a 45° side viewing angle.

2. The electroluminescent display device of claim 1, wherein the PL spectrum of the light emitting layer has the peak wavelength equal to or greater than 520 nm and less than 528 nm.

3. The electroluminescent display device of claim 1, wherein the PL spectrum of the light emitting layer has the peak wavelength equal to or greater than 524 nm and less than 528 nm.

4. The electroluminescent display device of any of claims 1 to 3, wherein the PL spectrum of the light emitting layer has a first peak and a second peak positioned at a longer wavelength than the first peak, and an intensity of the second peak is less than 0.5 times an intensity of the first peak, preferably 0.46 times or less than 0.46 times an intensity of the first peak.

5. The electroluminescent display device of any of claims 1 to 4, wherein the PL spectrum of the light emitting layer has a full width at half maximum (FWHM) equal to or greater than 32 nm and less than 62 nm.

6. The electroluminescent display device of any of claims 1 to 5, wherein the OC curve of the light emitting unit (500) has the peak wavelength ranging from 526 nm to 554 nm at the front viewing angle.

7. The electroluminescent display device of claim 6, wherein the OC curve of the light emitting unit (500) has a full width at half maximum (FWHM) of 41 nm or more and 50 nm or less at the front viewing angle.

8. The electroluminescent display device of any of claims 1 to 7, wherein the OC curve of the light emitting unit (500) has the peak wavelength ranging from 496 nm to 511 nm at the 45° side viewing angle.

9. The electroluminescent display device of claim 8, wherein the OC curve of the light emitting unit (500) has a full width at half maximum (FWHM) of 32 nm or more and 34 nm or less at the 45° side viewing angle.

10. The electroluminescent display device of any of claims 1 to 5, wherein the OC curve of the light emitting unit (500) has the peak wavelength ranging from 526 nm to 542 nm at the front viewing angle.

11. The electroluminescent display device of claim 10, wherein the OC curve of the light emitting unit (500) has a full width at half maximum (FWHM) of 47 nm or more and 50 nm or less at the front viewing angle.

12. The electroluminescent display device of any of claims 1 to 5, 10, or 11, wherein the OC curve of the light emitting unit (500) has the peak wavelength ranging from 496 nm to 508 nm at the 45° side viewing angle.

13. The electroluminescent display device of claim 12, wherein the OC curve of the light emitting unit (500) has a full width at half maximum (FWHM) of 33 nm or more and 34 nm or less at the 45° side viewing angle.

14. The electroluminescent display device of claim 12 or 13, wherein a luminance of a light emitted from the light emitting unit (500) is 38% to 58% at the 45° side viewing angle.

15. The electroluminescent display device of any of claims 1 to 14, wherein the light emitting layer is a green light emitting layer (G-EML) disposed in a green sub-pixel, the green light emitting layer (G-EML) includes a host material and a dopant material, and the dopant material includes an iridium or platinum metal complex.
